# EUROPÄISCHE PATENTSCHRIFT

(11) **EP 2 071 644 B1**
(45) Veröffentlichungstag und Bekanntmachung des Hinweises auf die Patenterteilung: **06.07.2011**
(21) Anmeldenummer: 08105783.8
(22) Anmeldetag: 12.11.2008
(51) Int. Cl.: H01L 41/047, H01L 41/083

(54) **Anordnung mit einem Piezoaktor mit mehreren Aktiv- und/oder zusätzlichen Sensorbereichen**
Device with a piezoelectric actuator having a plurality of active regions and/or additional sensor regions
Dispositif avec un actionneur piézoélectrique comprenant une multiplicité de parties actives et/ou de parties détectrices supplémentaires

(30) Priorität: 13.12.2007 DE 102007060052
(43) Veröffentlichungstag der Anmeldung: 17.06.2009
(73) Patentinhaber: ROBERT BOSCH GMBH, 70442 Stuttgart (DE)
(72) Erfinder: Hagemann, Benjamin, 70839 Gerlingen (DE)

(56) Entgegenhaltungen:
- DE-A1- 10 345 730
- DE-A1- 19 802 302
- JP-A- 7 223 315
- JP-A- 2002 246 666

## Beschreibung

### Stand der Technik

Die Erfindung betrifft eine Anordnung mit einem Piezoaktor, die aus einer Anordnung mit in den Lagenaufbau des Piezoaktors integrierten Sensorbereichen besteht, nach den gattungsgemäßen Merkmalen der Ansprüche 1 und 2.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Die Piezoelemente sind aus Piezolagen aus einem Piezomaterial mit einer geeigneten Kristallstruktur so aufgebaut, dass bei Anlage einer elektrischen Spannung an Innenelektroden, die die Piezolagen einschließen, eine mechanische Reaktion der Piezoelemente erfolgt. Diese Reaktion stellt in Abhängigkeit von der Kristallstruktur und der Anlagebereiche der elektrischen Spannung einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist. Jede Piezolage ist auch hier zwischen zwei Innenelektroden als sogenanntes Interdigitaldesign eingefasst, über die von außen eine elektrische Spannung mit jeweils unterschiedlicher Polarität angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Beispielsweise aus der DE 103 45 730 A1 sind darüber hinaus Piezoaktoren bekannt, bei denen Bereiche des Piezoaktors als Sensor genutzt werden, die beispielsweise eine Druckbelastung detektieren und diese über ein weiterverarbeitbares proportionales elektrisches Signal anzeigen und/oder auswerten können. Diese Sensorbereiche werden hier typischerweise über ein zweites Paar an Außenelektroden elektrisch kontaktiert. Durch eine solche Sensorfunktionalität kann zum Beispiel der Zustand des Piezoaktors überwacht werden; das Ausgangssignal der Sensorbereiche kann jedoch auch zur Steuerung des aktiven Piezoaktorbereichs genutzt werden.

Bei diesen bekannten CR-Injektoren ist in der Regel eine indirekt vom Piezoaktormodul gesteuerte Düsennadel als Kraftstoffventil vorhanden, wobei die Piezoaktoren eine Realisierung der Öffnungs- und Schließfunktion ermöglicht. Für eine Anwendung in Piezoinjektoren für größere Hubleistungen können auch mindestens zwei Piezoaktoren stirnseitig zu einer Aktorreihe aneinandergefügt werden. Es ist dabei auch hinlänglich bekannt, mehrere auch verschieden aufgebaute Piezoaktoren mit gegebenenfalls integrierten Sensorbereichen in einer Anordnung aus aneinandergeschalteten Piezoaktoren in einem Piezoaktormodul unterzubringen, die dann jeweils mit einem eigenen Außenelektrodenpaar kontaktiert werden.

In der Schrift JP 07 223315 A ist ein Piezoaktor mit einem Mehrschichtaufbau von Piezolagen offenbart, wobei zwischen den Piezolagen Innenelektroden angeordnet sind und diese auf einer Seite des Piezoaktors durch zwei Außenelektroden ansteuerbar sind.

In der Schrift JP 2002 246666 A ist ein Piezoaktor mit einem Mehrschichtaufbau von Piezolagen offenbart, wobei die Piezolagen als Aktorteil und Sensorteil ausgebildet sind. Dabei befinden sich die Sensorteile auf einer Schicht mit den Aktorteilen.

### Offenbarung der Erfindung

Bekannt ist eine Anordnung mit einem Piezoaktor, die aus einer Anordnung von mehreren mechanisch in Reihe geschalteten unabhängig ansteuerbaren aktiven Bereichen besteht, wobei der Piezoaktor aus in der mechanischen Wirkungsrichtung hintereinander geschalteten Piezoelementen mit über Außenelektroden unterschiedlicher Polarität kontaktierten Innenelektroden wechselnder Polarität für eine Spannungsbeaufschlagung besteht. Innerhalb der Anordnung mit mehreren mechanisch in Reihe geschalteten Aktivbereichen ist das Design der Innenelektroden so gestaltet, dass eine Polarität der Innenelektroden des Piezoaktors an eine gemeinsame Außenelektrode an einem gemeinsamen seitlichen Bereich des Piezoaktors anschaltbar ist und die jeweils andere Polarität der Innenelektroden der verschiedenen Aktivbereiche an verschiedene, seitlich am Piezoaktor angeordnete weitere Außenelektroden anschaltbar ist.

Gemäß einer erfindungsgemäßen Ausführungsform mit vier- oder mehreckigem Aufbau geht die Erfindung von einer Anordnung mit einem Piezoaktor mit einem Aktivbereich und von einem in den Lagenaufbau des Piezoaktors integrierten Sensorbereich aus, wobei der Piezoaktor hier aus in der mechanischen Wirkungsrichtung hintereinander geschalteten Piezoelementen mit über Außenelektroden unterschiedlicher Polarität für eine Spannungsbeaufschlagung im Aktivbereich kontaktierten Innenelektroden wechselnder Polarität besteht. Der Sensorbereich besteht hier aus Piezoelementen mit über Außenelektroden unterschiedlicher Polarität kontaktierten Innenelektroden wechselnder Polarität für eine Messsignalabnahme. Innerhalb der Anordnung des Piezoaktoren mit dem Aktivbereich und dem Sensorbereich ist das Design der Innenelektroden erfindungsgemäß so gestaltet, dass eine Polarität der Innenelektroden des Aktivbereichs und des Sensorbereichs in vorteilhafter Weise an eine gemeinsame Außenelektrode an einer gemeinsamen seitenfläche des Piezoaktors und die andere Polarität der Innenelektroden des Aktivbereichs und des Sensorbereichs an die jeweils anderen Außenelektroden an weiteren, jeweils verschiedenen Seitenflächen des Piezoaktors anschaltbar ist.

Solche Anordnungen können in vorteilhafter Weise Bestandteil eines Piezoinjektors mit einer Nadelhubsteuerung für ein Einspritzsystem für Kraftstoff bei einem Verbrennungsmotor sein.

Mit der Erfindung wird somit auf einfache Weise eine Reduktion der Anzahl der benötigten Außenelektroden erreicht. Dadurch werden zum einen die Kosten in der Aufbringung der Außenelektroden und zum anderen auch die Kosten für die elektrische Kontaktierung gesenkt, wobei insbesondere die Aufbringung der Außenelektroden ein mehrstufiger, komplizierter und dadurch kostspieliger Prozess ist.

Durch die Nutzung einer gemeinsamen Außenelektrode für verschiedene Aktiv- und Sensorbereiche des erfindungsgemäßen Piezoaktors kann jeder weitere zusätzlich zu dem typischerweise vorhandenen Aktivbereich hinzukommende Sensor- oder Aktivbereich mit nur einer zusätzlichen Außenelektrode elektrisch angebunden und angesteuert werden.

Es ist hierbei auf einfache Weise möglich, dass das Design der Innenelektroden so gestaltet ist, dass bei einem vier- oder mehreckigen Aufbau die gemeinsame Außenelektrode an einer Seitenfläche angebracht ist und die jeweils anderen Außenelektroden zum Beispiel gegenüberliegend und auf einer weiteren Seitenfläche angebracht sind. Bei einem runden Aufbau ist die gemeinsame Außenelektrode an einer Stelle des Umfangs in der Längserstreckung angebracht und die jeweils anderen Außenelektroden sind auf dem Umfang seitlich verteilt angebracht.

Vorteilhaft ist hierbei auch, wenn jede zweite Innenelektrode im Lagenaufbau an die gemeinsame Außenelektrode geschaltet ist, wobei in besonders vorteilhafter Weise gemäß einer Ausführungsform die gemeinsame Außenelektrode mit dem Massepotenzial verbunden ist.

Es ist weiterhin in vorteilhafter Weise möglich, dass, wie es für sich gesehen aus dem Stand der Technik bekannt ist, mehrere Aktivbereiche und/oder Sensorbereiche in ihrem Lagenaufbau mechanisch und geometrisch parallel geschaltet sind. Dies kann durch eine entsprechende Ausgestaltung der Innenelektroden erreicht werden, bei der die Innenelektroden in mehrere unabhängige Segmente unterteilt sind. Dadurch ist beispielsweise auch die Auswertung einer Druckverteilung im Inneren eines Piezoaktors möglich. Auch bei einer solchen Parallelanordnung wird erfindungsgemäß eine gemeinsame Außenelektrode für mehrere Aktiv- und Sensorbereiche gemeinsam genutzt.

### Kurze Beschreibung der Zeichnung

Ein Ausführungsbeispiel des erfindungsgemäßen Piezoaktors wird anhand der Figuren der Zeichnung erläutert. Es zeigen:
Figur 1 einen Schnitt durch einen bekannten Piezoaktor,
Figur 2 eine Ansicht auf ein erfindungsgemäßes Design einer Innenelektrode am gemeinsamen Massepotenzial,
Figur 3 eine Ansicht auf ein erfindungsgemäßes Design einer Innenelektrode am Pluspotenzial und
Figur 4 eine Ansicht auf ein erfindungsgemäßes Design einer Innenelektrode am Pluspotenzial eines weitern Piezoaktors oder eines Sensorbereichs.

### Weg zur Ausführung der Erfindung

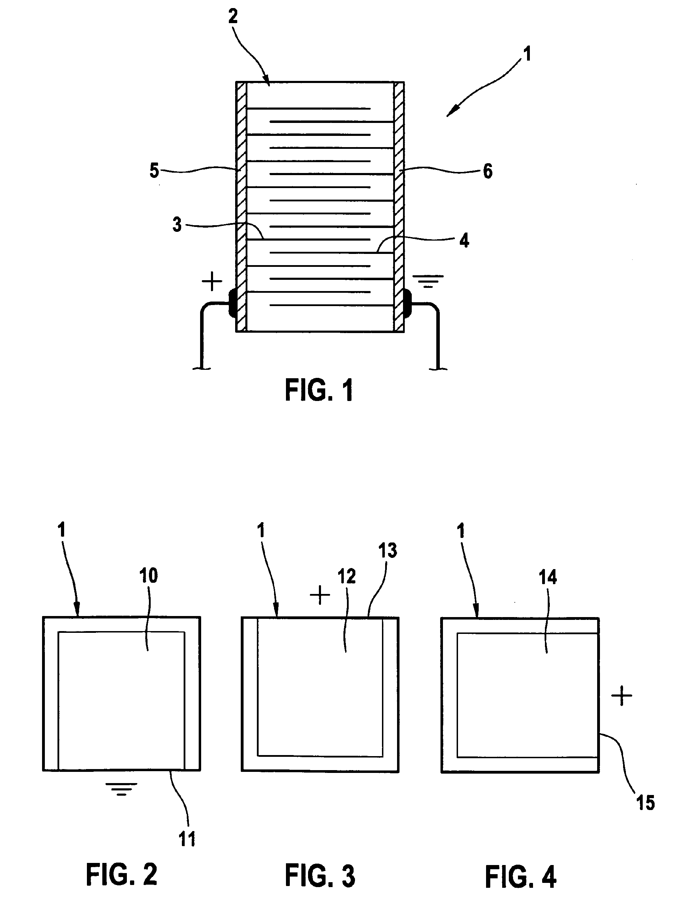

Im Folgenden wird anhand Figur 1 ein an sich bekannter Piezoaktor 1 im Prinzip erläutert, der beispielsweise für einen Piezoinjektor zur Nadelhubsteuerung in einem Einspritzsystem für Kraftstoff bei einem Verbrennungsmotor eingesetzt werden kann, wie es eingangs anhand des Standes der Technik beschrieben ist. Der Piezoaktor 1 ist dazu in bekannter Weise aus Piezolagen 2 mit einer geeigneten Kristallstruktur so aufgebaut, dass unter Ausnutzung des sogenannten Piezoeffekts bei Anlage einer äußeren elektrischen Spannung an Elektroden 3 und 4 über Außenelektroden 5 und 6 eine mechanische Reaktion in Richtung des Lagenaufbaus des Piezoaktors 1 erfolgt.

Aus Figur 2 ist das Design einer Innenelektrode 10, beispielsweise in einem möglichen Lagenaufbau, vergleichbar dem Piezoaktor 1 nach der Figur 1, zu entnehmen. Hier ist ersichtlich, dass die Innenelektrode 10 an einer Seitenfläche 11 des Piezoaktors 1 mit dem Massepotenzial verbunden ist und somit gemeinsam mit anderen Innenelektroden des Piezoaktors 1 an eine Außenelektrode (entsprechend Außenelektrode 6 nach der Figur 1) angeschlossen werden kann.

Figur 3 zeigt das Design einer Innenelektrode 12, die beispielsweise an einer gegenüberliegenden Seitenfläche 13 eines Piezoaktors über die andere Außenelektrode (beispielsweise Außenelektrode 5 nach der Figur 1) mit dem Pluspol für eine Spannungsbeaufschlagung zur Erzeugung des Hubs des Piezoaktors verbunden ist. In Figur 4 ist ein weiteres Design einer Innenelektrode 14 gezeigt, die beispielsweise an einer weiteren Seitenfläche 15 des Piezoaktors über eine weitere Außenelektrode mit dem Pluspol (z. B. Amplituden bis zu 10V oder Betriebsspannung) für eine Spannungsbeaufschlagung eines weiteren hier nicht dargestellten in Reihe geschalteten Aktivbereichs zur Erzeugung des Hubs des weiteren Aktivbereichs in einem ersten erfindungsgemäßen Ausführungsbeispiel verbunden ist.

In einem erfindungsgemäßen Ausführungsbeispiel ist ein Teilbereich eines Piezoaktors als Aktivbereich des Piezoaktors (entsprechend Piezoaktor 1 nach der Figur 1) und ein zweiter Teilbereich als hier nicht dargestellter Sensorbereich aufgebaut. Ein solcher Sensorbereich ist in der, in der Beschreibungseinleitung erwähnten DE 103 45 730 A1 ausführlich beschrieben. Hiermit kann erreicht werden, dass wenn der Aktivbereich des Piezoaktors von außen über die Außenelektroden der Seitenflächen 11 und 13 gemäß der Figuren 2 und 3 mit einem beispielsweise sinusförmigen Spannungssignal beaufschlagt wird, welches dann zu einer mechanischen Dehnung dieses Bereichs führt, im Sensorbereich durch den sich ändernden Druck auf den Piezoaktor die erzeugten Signale an den Außenelektroden der Seitenflächen 11 und 15 gemäß der Figuren 2 und 4 abgegriffen werden können.

Das erfindungsgemäße Design der Innenelektroden 10,12,14 kann hierbei in viereckiger Quaderform ausgeführt werden, bei der die drei Seitenflächen 11,13,15 und eine weitere vorhanden sind. In weiteren hier nicht dargestellten Ausführungsbeispielen ist ein Piezoaktor nicht viereckig, sondern beispielsweise rund, elliptisch oder als n-Eck ausgeführt. Zusätzlich sind beliebige Kombinationen aus Aktiv- und Sensorbereichen mit entsprechend ausgestalteten Innenelektroden und Außenelektroden denkbar, die je nach Anwendungsfall mit einem entsprechenden erfindungsgemäßen Design ausgestattet werden können. Insbesondere ist nicht nur eine Reihenschaltung aus verschiedenen Aktiv- und Sensorbereichen, sondern auch eine Parallelschaltung solcher Bereiche möglich.

Die Innenelektroden 10,12,14 können dabei so aufgebaut werden, dass jeweils die eine Hälfte des Aktiv- und des Sensorbereichs an der gleichen Außenelektrode 11 (hier das Massepotenzial) angebunden ist und diese sich damit diese Außenelektrode an der Seitenfläche 11 teilen, während jeweils die andere Hälfte des Aktiv- und des Sensorbereichs zu jeweils unterschiedlichen Außenelektroden geführt werden. Eine Anordnung mit einer gemeinsamen Nutzung eines anderen Potenzials ist hierbei jedoch ebenfalls möglich. Die verschiedenen Aktiv- und Sensorbereiche müssen nicht gleich groß bzw. mit gleicher Schichtzahl aufgebaut sein. Zudem ist es möglich, verschiedene Bereiche durch passive Schichten ohne Innenelektroden zu trennen.

## Patentansprüche

1. Anordnung mit einem Piezoaktor (1), der einen vier - oder mehreckigen Aufbau aufweist, und mindestens einem in den Lagenaufbau des Piezoaktors (1) integrierten Sensorbereich, bei der der Piezoaktor (1) aus in der mechanischen Wirkungsrichtung hintereinander geschalteten Piezoelementen mit über Außenelektroden (5,6) unterschiedlicher Polarität für eine Spannungsbeaufschlagung im Aktivbereich kontaktierten Innenelektroden (3,4) wechselnder Polarität und der Sensorbereich ebenfalls aus Piezoelementen mit über Außenelektroden unterschiedlicher Polarität kontaktierten Innenelektroden wechselnder Polarität für eine Messsignalabnahme besteht, wobei innerhalb der Anordnung des Piezoaktors mit dem Aktivbereich und dem Sensorbereich das Design der Innenelektroden (10,12,14) so gestaltet ist, dass eine Polarität der Innenelektroden (10) des Aktivbereichs und eines oder mehrerer Sensorbereiche an eine gemeinsame Außenelektrode an einer gemeinsamen Seitenfläche des Piezoaktors anschaltbar ist, **dadurch gekennzeichnet, dass** die andere Polarität der Innenelektroden (12,14) des Aktivbereichs und des Sensorbereichs an die jeweils anderen Außenelektroden an weiteren, jeweils verschiedenen Seitenflächen des Piezoaktors anschaltbar ist.

2. Anordnung mit einem Piezoaktor (1) und mindestens einem in den Lagenaufbau des Piezoaktors (1) integrierten Sensorbereich, bei der der Piezoaktor (1) aus in der mechanischen Wirkungsrichtung hintereinander geschalteten Piezoelementen mit über Außenelektroden (5,6) unterschiedlicher Polarität für eine Spannungsbeaufschlagung im Aktivbereich kontaktierten Innenelektroden (3,4) wechselnder Polarität und der Sensorbereich ebenfalls aus Piezoelementen mit über Außenelektroden unterschiedlicher Polarität kontaktierten Innenelektroden wechselnder Polarität für eine Messsignalabnahme besteht, **dadurch gekennzeichnet, dass**
der Piezoaktor einen runden oder elliptischen Aufbau aufweist und innerhalb der Anordnung des Piezoaktors mit dem Aktivbereich und dem Sensorbereich das Design der Innenelektroden (10,12,14) so gestaltet ist, dass eine Polarität der Innenelektroden (10) des Aktivbereichs und eines oder mehrerer Sensorbereiche an eine gemeinsame Außenelektrode an einer Stelle des Umfangs in der Längserstreckung angebracht ist und die jeweils andere Polarotät an verschiedene Außenelektroden anschaltbar ist, die auf dem Umfang seitlich verteilt angebracht sind.

3. Anordnung nach Anspruch 1 oder 2, **dadurch gekennzeichnet, dass** jede zweite Innenelektrode (10) im Lagenaufbau an die gemeinsame Außenelektrode geschaltet ist.

4. Anordnung nach einem der Ansprüche 1 bis 3, **dadurch gekennzeichnet, dass** die Innenelektrode (10), die im Lagenaufbau an die gemeinsame Außenelektrode geschaltet ist, mit dem Massepotenzial verbunden ist.

5. Anordnung nach einem der Ansprüche 1 bis 4, durch **gekennzeichnet**, dass mehrere Aktiv- und/oder Sensorbereiche in ihrem Lagenaufbau mechanisch und geometrisch parallel und/oder in Reihe geschaltet sind.

6. Anordnung nach einem der Ansprüche 1 bis 5, **dadurch gekennzeichnet, dass** der oder die Piezoaktoren Bestandteil eines Piezoinjektors mit einer Nadelansteuerung für ein Einspritzsystem für Kraftstoff bei einem Verbrennungsmotor sind.

## Claims

1. Arrangement comprising a piezoactuator (1), which has a quadrangular or polygonal construction, and at least one sensor region integrated into the layer construction of the piezoactuator (1), in which arrangement the piezoactuator (1) consists of piezoelements connected one after another in the direction of mechanical action and having internal electrodes (3, 4) of alternating polarity that are contact-connected via external electrodes (5, 6) of differing polarity for applying voltage in the active region, and the sensor region likewise consists of piezoelements having internal electrodes of alternating polarity that are contact-connected via external electrodes of differing polarity for measurement signal tapping, wherein, within the arrangement of the piezoactuator comprising the active region and the sensor region, the design of the internal electrodes (10, 12, 14) is configured such that one polarity of the internal electrodes (10) of the active region and of one or more sensor regions can be connected to a common external electrode on a common side surface of the piezoactuator, **characterized in that** the other polarity of the internal electrodes (12, 14) of the active region and of the sensor region can be connected to the respective other external electrodes on further, respectively different side surfaces of the piezoactuator.

2. Arrangement comprising a piezoactuator (1), and at least one sensor region integrated into the layer construction of the piezoactuator (1), in which arrangement the piezoactuator (1) consists of piezoelements connected one after another in the direction of mechanical action and having internal electrodes (3, 4) of alternating polarity that are contact-connected via external electrodes (5, 6) of differing polarity for applying voltage in the active region, and the sensor region likewise consists of piezoelements having internal electrodes of alternating polarity that are contact-connected via external electrodes of differing polarity for measurement signal tapping, **characterized in that**
the piezoactuator has a round or elliptical construction and, within the arrangement of the piezoactuator comprising the active region and the sensor region, the design of the internal electrodes (10, 12, 14) is configured such that one polarity of the internal electrodes (10) of the active region and of one or more sensor regions is applied to a common external electrode at a location of the circumference in the longitudinal extent and the respective other polarity can be connected to different external electrodes which are applied in a manner distributed laterally on the circumference.

3. Arrangement according to Claim 1 or 2, **characterized in that** every second internal electrode (10) in the layer construction is connected to common external electrode.

4. Arrangement according to any of Claims 1 to 3, **characterized in that** the internal electrode (10) which is connected to the common external electrode in the layer construction is connected to the earth potential.

5. Arrangement according to any of Claims 1 to 4, **characterized in that** a plurality of active and/or sensor regions are connected in parallel and/or in series mechanically and geometrically in their layer construction.

6. Arrangement according to any of Claims 1 to 5, **characterized in that** the piezoactuator or piezoactuators is or are part of a piezoinjector with a needle driving unit for an injection system for fuel in an internal combustion engine.

## Revendications

1. Système doté d'un piézoactionneur (1) qui présente une structure en quadrilatère ou en polygone ainsi qu'au moins une zone de détection intégrée dans la structure stratifiée du piézoactionneur (1),
le piézoactionneur (1) étant constitué de piézoéléments raccordés les uns à la suite des autres dans une direction d'action mécanique et dotés d'électrodes extérieures (5, 6) de polarités différentes en vue d'appliquer des tensions de polarité alternée sur des électrodes intérieures (3, 4) en contact avec la zone active,
la zone de détection étant également constituée de piézoéléments dotés d'électrodes intérieures de polarité alternée en contact avec des électrodes extérieures de polarité alternée en vue de permettre de prélever un signal de mesure,
la configuration des électrodes intérieures (10, 12, 14) dans le système de piézoactionneur doté de la zone active et de la zone de détection étant telle qu'une polarité des électrodes intérieures (10) de la zone active et d'une ou plusieurs zones de détection peut être raccordée à une électrode extérieure commune située sur une surface latérale commune du piézoactionneur,
**caractérisé en ce que**
l'autre polarité des électrodes intérieures (12, 14) de la zone active et de la zone de détection peut être raccordée aux autres électrodes extérieures du piézoactionneur sur d'autres surfaces latérales, chaque fois différentes.

2. Système doté d'un piézoactionneur (1) qui présente au moins une zone de détection intégrée dans la structure stratifiée du piézoactionneur (1),
le piézoactionneur (1) étant constitué de piézoéléments raccordés les uns à la suite des autres dans une direction d'action mécanique et dotés d'électrodes extérieures (5, 6) de polarités différentes en vue d'appliquer des tensions de polarité alternée sur des électrodes intérieures (3, 4) en contact avec la zone active,
la zone de détection étant également constituée de piézoéléments dotés d'électrodes intérieures de polarité alternée en contact avec des électrodes extérieures de polarité alternée en vue de permettre de prélever un signal de mesure,
**caractérisé en ce que**
le piézoactionneur présente une structure circulaire ou elliptique et la configuration des électrodes intérieures (10, 12, 14) à l'intérieur du système du piézoactionneur doté de la zone active et de la zone de détection est telle qu'une polarité des électrodes intérieures (10) de la zone active et d'une ou plusieurs zones de détection est placée sur une électrode extérieure commune en un emplacement de la périphérie situé dans l'extension longitudinale et l'autre polarité peut être raccordée à des électrodes extérieures différentes qui sont réparties latéralement à la périphérie.

3. Système selon les revendications 1 ou 2, **caractérisé en ce que** chaque deuxième électrode intérieure (10) est raccordée dans la structure stratifiée à l'électrode extérieure commune.

4. Système selon l'une des revendications 1 à 3, **caractérisé en ce que** l'électrode intérieure (10) raccordée à l'électrode extérieure commune dans la structure stratifiée est reliée au potentiel de masse.

5. Système selon l'une des revendications 1 à 4, **caractérisé en ce que** plusieurs zones actives et/ou zones de détection sont raccordées mécaniquement dans la structure stratifiée et géométriquement en parallèle et/ou en série.

6. Système selon l'une des revendications 1 à 5, **caractérisé en ce que** le ou les piézoactionneurs font partie d'un piézoinjecteur doté d'une commande de pointeau pour un système d'injection de carburant dans un moteur à combustion interne.
